## Europäisches Patentamt

## European Patent Office

## Office européen des brevets

(11) Publication number: **0 021 655**
**B1**

(12) # EUROPEAN PATENT SPECIFICATION

(45) Date of publication of patent specification: **27.04.83**

(21) Application number: **80301869.6**

(22) Date of filing: **04.06.80**

(51) Int. Cl.³: **H 01 J 37/09,**
**H 01 J 37/26, H 01 J 37/30**

(54) Electron beam irradiation apparatus.

(30) Priority: **12.06.79 JP 72976/79**

(43) Date of publication of application:
**07.01.81 Bulletin 81/1**

(45) Publication of the grant of the patent:
**27.04.83 Bulletin 83/17**

(84) Designated Contracting States:
**DE FR GB NL**

(56) References cited:
**DE - B - 1 514 259**
**DE - C - 926 266**
**FR - A - 910 626**
**US - A - 3 736 457**
**US - A - 4 082 958**

(73) Proprietor: **FUJITSU LIMITED**
**1015, Kamikodanaka Nakahara-ku**
**Kawasaki-shi Kanagawa 211 (JP)**

(72) Inventor: **Iijima, Nobuo**
**3016-1-416, Nagatsuda-cho**
**Midori-ku Yokohama-shi, Kanagawa 227 (JP)**

(74) Representative: **Abbott, Leonard Charles et al,**
**GILL JENNINGS & EVERY 53/64 Chancery Lane**
**London WC2A 1HN (GB)**

Courier Press, Leamington Spa, England.

Electron beam irradiation apparatus

This invention relates to an electron beam irradiation apparatus comprising a source for producing an electron beam, and a movable platform mounted on a base plate, such as an electron beam exposure apparatus or an electron microscope, and more particularly relates to a magnetic shield construction for avoiding magnetic disturbance of the electron beam.

An electron beam irradiation apparatus is used in a pattern formation process for producing semi-conductor devices, or in an electron microscope for inspecting the formed patterns of semiconductor devices. A movable platform, such as an XY platform, is installed within a vacuum chamber of the electron beam irradiation apparatus. An electron beam is applied to a specimen placed on a table of the XY platform. An XY platform operable at high speed and with high positioning accuracy is used, especially in exposure apparatus for forming semiconductor patterns US—A—4082958. If movable parts of the XY platform are made of a ferromagnetic substance, magnetism from the platform changes as the table moves. This causes the path of the electron beam to be deflected, so that a desired pattern cannot be obtained. Making the platform of a non-ferromagnetic substance involves a great deal of trouble in processing and causes the cost to be high. Even if the platform is made of a non-ferromagnetic substance, magnetism from a drive system or other movable parts outside the platform can affect the electron beam.

It is an object of the present invention to provide a magnetic shield construction for a movable platform such as an XY platform, so as to make it possible to produce the platform using a ferromagnetic material, such as iron, which is cheap and can be machined with a high cutting or processing accuracy. The magnetic shield construction of the present invention protects the electron beam from the effects of the magnetism of the platform or outer parts without degrading the functional ability of the platform.

According to the present invention, the base plate is formed of a magnetically permeable material; side members of high permeability are disposed around the platform; a magnetic shield cover plate covers a table surface of the platform; and a magnetic shield plate is magnetically connected to the base plate through the side members and is disposed across the path of the electron beam, the shield plate having an aperture through which the electron beam passes; whereby disturbance of the electron beam by magnetic fields originating from the movable platform is reduced.

An embodiment of the invention will now be described, by way of example, with reference to the accompanying drawings, in which:

Fig. 1 is a schematic sectional view of a magnetic shield constructed in accordance with the present invention,

Fig. 2 is a schematic sectional view of an example of an electron beam irradiation apparatus including a magnetic shield constructed according to the present invention.

Figs. 3, 4 and 5 are graphs of experimental results representing the magnetism value at a point above an XY platform of the apparatus,

Figs. 6 to 8 are schematic sectional views for explaining the principle of the magnetic shield according to the present invention.

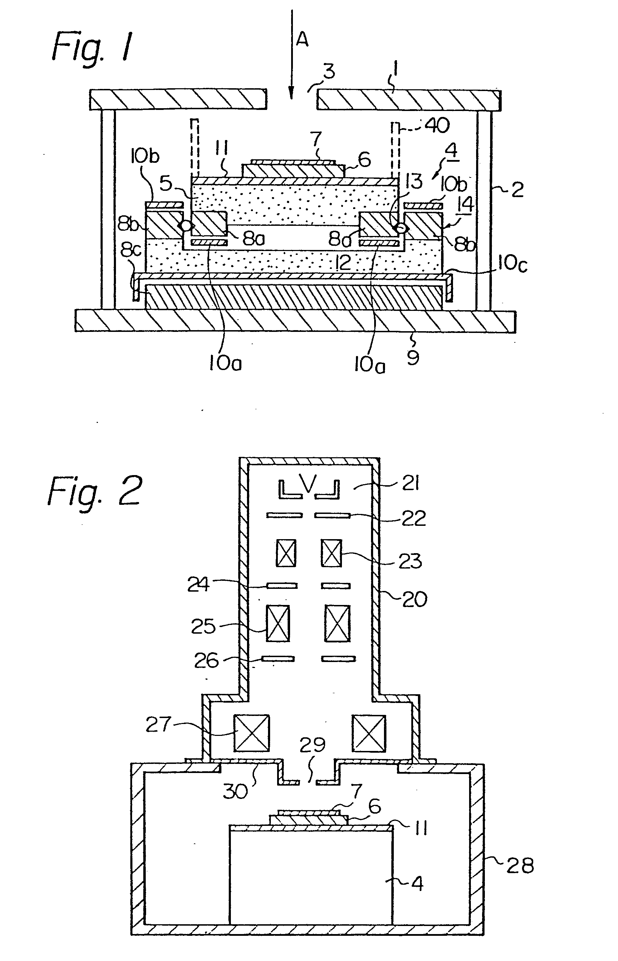

An embodiment of the present invention is illustrated in a sectional view in Fig. 1. An XY platform 4 is mounted on a base plate 9 of a high permeability material, such as pure iron. Pillars 2 of pure iron which form the side members are mounted on the base plate 9. An upper magnetic shield plate 1 of a high permeability material (permalloy, ferrite etc.) is disposed above the XY platform 4 and is supported by the pillars 2. In this arrangement, the base plate 9 and the shield plate 1 are magnetically interconnected through the pillars. An aperture 3 for passage of an electron beam (arrow A) is formed at the centre of the plate 1. The surface of a table 5 of the XY platform 4 is covered by a magnetic shield cover plate 11 of permalloy or similar material, having the same dimensions as the table surface. A wafer holder 6 is mounted on the table 5. A wafer 7 such as silicon substrate, to which the electron beam is to be applied, is placed on the wafer holder 6.

The table 5 is arranged for movement in the "Y" direction and is mounted on an "X" direction movement table 12 through guide means 14, which are made of a magnetic material, such as iron. The Y table 5 and the X table 12 are made of, for example, an aluminium alloy. Each of the guide means 14 comprises a steel ball 13 and a pair of guide rails 8a and 8b which are secured to the Y table 5 and the X table 12, respectively. The guide means 14 is connected to a drive which comprises a drive screw (not shown), a motor (not shown) and a magnetic fluid rotation introducer (not shown) disposed within the vacuum chamber. The lower surface of each guide rail 8a is covered by a further magnetic shield plate 10a, made of a permalloy or similar magnetic material. The upper surface of each guide rail 8b is covered by another further magnetic shield plate 10b, made of a permalloy or similar material. Also, the upper surface of another guide rail 8c, secured to the base plate 9, is covered by another further magnetic shield plate 10c. Similarly, a guide for movement in the X direction is arranged between the X table 12 and the base plate 9.

In the XY platform 4 of the above-described construction, since the whole platform is magnetically enclosed by a material of a high

permeability, such as a permalloy, it is possible to decrease the magnetism above the table and reduce the change in magnetism caused by the movement of the platform. Hence, the magnetic disturbance caused by the XY platform upon the electron beam can be reduced so as to be negligible.

In such a magnetic shield construction, magnetic disturbance by the driving system which is disposed outside the construction, can also be avoided. Hence, stable and reliable electron beam irradiation can be obtained. The upper shield plate 1 (Fig. 1) also protects the wafer 7 from the magnetic effects of electron lenses disposed above the shield plate. In an apparatus in which the electron beam is deflected by electromagnetic force, it is desirable to dispose ferrite material around the beam passage aperture 3 of the shield plate 1, in order to avoid eddy currents. The magnetic shield effect can be enhanced by using a wafer holder 6 of high permeability and low hysteresis. The shield effect can be further enhanced by providing a shield wall 40 around the periphery of the table 5, as illustrated by dotted lines in Fig. 1.

An example of an electron beam irradiation apparatus comprising a magnetic shield construction according to the present invention is illustrated in Fig. 2. An electron beam source 21, an anode 22 for accelerating the electron beam, a beam aligner 23 for correcting the beam path, diaphragm slit plates 24 and 26, a condenser electron lens 25, and an object electron lens 27 are disposed within a column body 20. A shield plate 30 having a beam passage hole 29 is secured to the lower end of the column body 20. This shield plate 30 is made of a high permeability material, such as a permalloy. The column body 20, provided with the shield plate 30, is mounted on a vacuum chamber 28 which is made of a high permeability material, such as iron. An XY platform 4, which is substantially the same as that of Fig. 1, is installed within the vacuum chamber 28. In this arrangement, a magnetic shield construction which encloses the platform 4 is formed by the base plate, the side walls and the ceiling of the vacuum chamber 28 and the shield plate 30 secured to the column body 20.

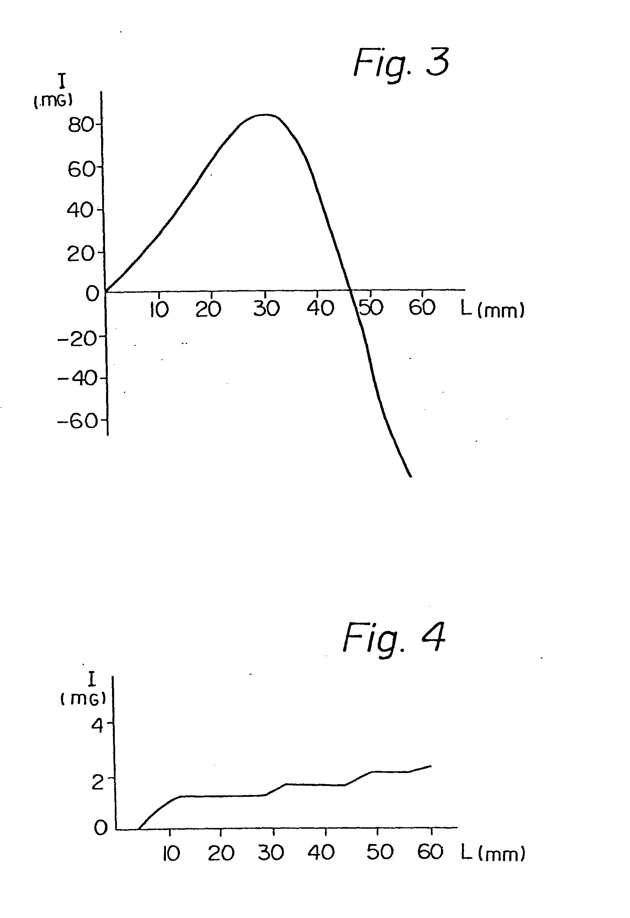

Experimental results of the change in magnetism above the table of the XY platform are represented in Figs. 3 and 4. This experiment was made in the following manner. The wafer holder 6 and the wafer 7 were removed from the apparatus in this experiment. A magnetism sensor was inserted into the apparatus through the beam passage hole 3 and disposed on the centre axis of the hole 3 at the location and at the level at which the wafer 7 would be positioned in actual use. Then the XY platform was moved in either the X direction or the Y direction or in both directions. The platform was mounted on an iron base plate. A permalloy plate was supported above the platform by iron pillars. Fig. 3 represents the case without a magnetic shield cover plate on the table surface. Fig. 4 represents the case with a permalloy cover plate on the table surface. In each of the graphs, the abscissa represents the amount of shift L (mm) of the XY platform in the horizontal direction and the ordinate represents the magnetic intensity I (mG=$10^{-7}$T) measured at the beam passage hole. Magnetic intensity of the XY platform without the magnetic shield contruction of the present invention was 30~35 $\mu$T 300~350 mG. Magnetism corresponding to the difference between the maximum intensity and the minimum intensity acts upon the electron beam as a magnetic disturbance. In the case of Fig. 3, the magnetic disturbance value was about 17 $\mu$T (170 mG). In the case of Fig. 4, the magnetic disturbance value was about 0.3 $\mu$T (3 mG). The experimental results show that it is possible to reduce the magnetic disturbance upon the electron beam within a tolerance limit.

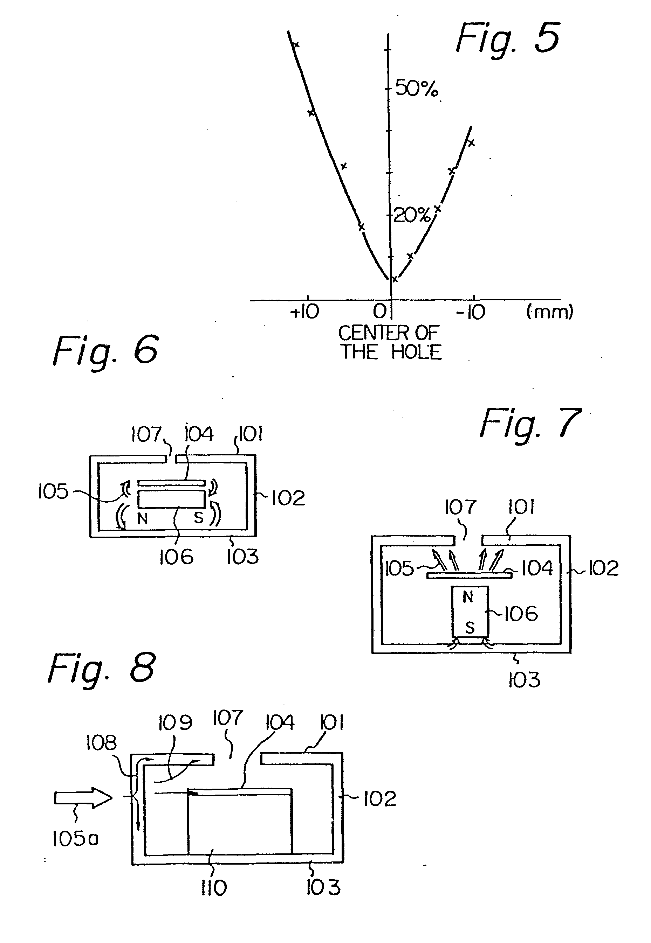

The magnetic shield effect of the present invention is graphically illustrated in Fig. 5. The graph represents a magnetic intensity distribution of leaked magnetism from the XY platform on the centre axis of, and around, the beam passage hole 3. As can be seen from the graph, the magnetic intensity on the centre axis of the beam passage hole 3 is only 2—3% of the magnetic intensity of the XY platform. Even at a point spaced 10 mm from the centre axis of the beam passage hole 3, the magnetic intensity is about 50% of the magnetic intensity of the XY platform. The distribution of the magnetic intensity is approximately represented by a parabolic line as illustrated in Fig. 5. In the area near the centre axis of the beam passage hole 3 (within 5 mm from the centre axis), the magnetic intensity is less than 10% of the magnetic intensity of the XY platform, that is, below a tolerance amount for electron beam irradiation. An exposure or scanning area of the electron beam irradiation apparatus is about 3 mm×3 mm. Therefore, the magnetic intensity in the area near the centre axis does not degrade the electron beam irradiation accuracy. A slight increase in the magnetic intensity in the area near the centre axis of the beam passage hole 3 can be compensated by a control circuit of the electron beam irradiation apparatus.

The principle of the magnetic shield according to the present invention will now be explained with reference to Figs. 6 to 8. Suppose the XY platform of a magnetic material acts as a magnet, and that this magnet comprises two components, one having horizontally disposed N and S poles, and the other having vertically disposed N and S poles. Magnetic flux 105 from each of the components flows as follows.

A horizontal magnet component is illustrated in Fig. 6. Magnetic flux 105 is emitted from the magnet 106, as shown by arrows, and flows into a magnetic shield plate 104 disposed above the magnet 106 and into shield members 101, 102, 103 which enclose the magnet 106 and the shield plate 104. Therefore, magnetic disturbance is minimized under the passage hole 107 of the shield member 101.

A vertical magnet component is illustrated in Fig. 7. Magnetic flux 105 emitted from the magnet 106 flows into the upper shield plate 101 through the magnetic shield plate 104 disposed above the magnet and then flows through the side members 102 and the base member 103. A dead space of magnetic flux is formed at the centre of the passage hole 107 of the upper shield plate 101. The dead space is maintained existent if the shield plate 104 is shifted, so that changes in magnetism due to the magnet movement are minimized.

The action of the magnetic shield construction of the present invention against magnetism from outside is explained with references to Fig. 8. Magnetic flux 105a from outside flows into the side plate 102 which forms a magnetic path 108. A part of the magnetic flux 105a penetrates the side member 102 and flows into the upper plate 101, as shown by an arrow 109, or flows into the shield plate 104. Therefore, the magnetic flux does not flow through the space under the passage hole 107.

## Claims

1. An electron beam irradiation apparatus, comprising a source for producing an electron beam (A), and a movable platform (4) mounted on a base plate (9), characterised in that the base plate is formed of a material of high magnetical permeability; side members (2) of high permeability are disposed around the platform; a magnetic shield cover plate (11) covers a table surface of the platform; and a magnetic shield plate (1) is magnetically connected to the base plate through the side members and is disposed across the path of the electron beam, the shield plate (1) having an aperture (3) through which the electron beam passes; whereby disturbance of the electron beam by magnetic fields (105) originating from the movable platform is reduced.

2. Apparatus according to Claim 1, characterised in that the platform (4) is an XY platform.

3. Apparatus according to Claim 1 or Claim 2, characterised by a further magnetic shield plate (10a, 10b, 10c) disposed along a drive guide member (8a, 8b, 8c) of the platform.

4. Apparatus according to any preceding claim, characterised by a magnetic shield wall (40) provided along the periphery of the magnetic shield cover plate (11).

5. Apparatus according to any preceding claim, characterised in that the platform (4) is housed within a vacuum chamber (28) formed of a material of high permeability; a floor plate and side plates of the vacuum chamber (28) serve as the base plate and the side members, respectively; a magnetic shield plate (30) having an aperture (29) for passage therethrough of the electron beam is disposed at the lower end of a column body (20) which houses an electron beam irradiation gun (21—27); and the magnetic shield plate (30) forms an upper plate of the vacuum chamber.

## Revendications

1. Appareil d'irradiation par faisceau électronique, comprenant une source servant à produire un faisceau électronique (A), et une plate-forme mobile (4) montée sur une plaque d'embase (9), caractérisé en ce que la plaque d'embase est formée d'un matériau de perméabilité élevée; des éléments latéraux (2) de perméabilité élevée sont disposés autour de la plate-forme; une plaque couvercle de blindage magnétique (11) couvre une surface du plateau de la plate-forme; et une plaque de blindage magnétique (1) est reliée magnétiquement à la plaque d'embase par l'intermédiaire des éléments latéraux et est disposée de manière à couper transversalement le trajet du faisceau électronique, la plaque de blindage (1) possédant une ouverture (3) dans laquelle passe le faisceau électronique; si bien que les perturbations du faisceau électronique par des champs magnétiques (105) venant de la plate-forme mobile sont réduites.

2. Appareil selon la revendication 1, caractérisé en ce que la plate-forme (4) est une plate-forme XY.

3. Appareil selon la revendication 1 ou 2, caractérisé par une autre plaque de blindage magnétique (10a, 10b, 10c) disposée le long d'un élément d'un guidage d'entraînement (8a, 8b, 8c) de la plate-forme.

4. Appareil selon l'une quelconque des revendications précédentes, caractérisé par une paroi de blindage magnétique (40) disposée suivant la périphérie de la plaque couvercle de blindage magnétique (11).

5. Appareil selon l'une quelconque des revendications précédentes, caractérisé en ce que la plate-forme (4) est logée à l'intérieur d'une chambre à vide (28) formée d'un matériau de perméabilité élevée; une plaque plancher et des plaques latérales de la chambre à vide (28) servent respectivement de plaque d'embase et d'éléments latéraux; une plaque de blindage magnétique (30) possédant une ouverture (29) destinée à laisser le passage au faisceau électronique est disposée à l'extrémité inférieure d'un corps de colonne (20) qui loge un canon d'irradiation par faisceau électronique (21 à 27); et la plaque de blindage magnétique (30) forme une plaque supérieure de la chambre à vide.

## Patentansprüche

1. Elektronenstrahl-Bestrahlungsvorrichtung mit einer Elektronenstrahlquelle (A), und einer beweglichen Plattform (4), welche auf einer Basisplatte (9) montiert ist, dadurch gekennzeichnet, daß die Basisplatte aus einem Material mit hoher magnetischer Permeabilität geformt ist, daß die Seitenteile (2) aus hochpermeablen Material um die Plattform herum angeordnet sind, daß eine magnetische Schirmdeckplatte (11) die Tischoberfläche der Plattform abdeckt, und daß eine magnetische Schirmplatte (1) magnetisch mit der Basisplatte über die Seitenteile verbunden und quer zu dem Weg des Elektronenstrahls angeordnet ist, und daß die Schirmplatte (1) eine Öffnung (3) aufweist, durch welche der Elektronenstrahl hindurchtritt, wodurch Störungen des Elektronenstrahls durch Magnetfelder (105), welche von der beweglichen Plattform verursacht werden, reduziert sind.

2. Vorrichtung nach Anspruch 1, dadurch gekennzeichnet, daß die Plattform (4) eine XY Plattform ist.

3. Vorrichtung nach Anspruch 1 oder 2, dadurch gekennzeichnet, daß ferner eine magnetische Schirmplatte (10a, 10b, 10c) längs dem Antriebsführungskörper (8a, 8b, 8c) der Plattform angeordnet ist.

4. Vorrichtung nach einem der vorhergehenden Ansprüche, dadurch gekennzeichnet, daß eine magnetische Schirmwand (40) längs dem Umfang der magnetischen Schirmabdeckplatte (11) angeordnet ist.

5. Vorrichtung nach einem der vorhergehenden Ansprüche, dadurch gekennzeichnet, daß die Plattform 4 innerhalb einer aus einem Material hoher Permeabilität gebildeten Vakuumkammer (28) untergebracht ist, eine Bodenplatte und Seitenplatten der Vakuumkammer (28) als die Grundplatte bzw. die Seitenkörper dienen, eine magnetische Schirmplatte (30) mit einer Öffnung (29) als Einlassöffnung für den Elektronenstrahl am unteren Ende des Säulenkörpers (20) vorgesehen ist, welcher eine Elektronenstrahlkanone (21—27) enthält, und die magnetische Schirmplatte (30) eine obere Platte der Vakuumkammer bildet.

*Fig. 1*

*Fig. 2*

Fig. 3

Fig. 4

# Fig. 5

# Fig. 6

# Fig. 7

# Fig. 8